# EUROPEAN PATENT APPLICATION

(11) **EP 0 744 753 A2**
(43) Date of publication of application: **27.11.1996**
(21) Application number: 96107977.9
(22) Date of filing: 20.05.1996
(51) Int. Cl.: G11C 7/06, G11C 11/56

(54) **Sense amplifiers**

(30) Priority: 20.05.1995 KR 9512691
(71) Applicant: SAMSUNG ELECTRONICS CO., LTD., Suwon-city, Kyungki-do 441-373 (KR)
(72) Inventor: Jung, Tae-Sung, Gunpo-City, Kyungki-Do (KR); Park, Jung-Hoon, Ahnyang-City, Kyungki-do (KR)
(74) Representative: Tunstall, Christopher Stephen

(57) **Abstract**

A sense amplifier is disclosed having a pair of pull-up transistors Q7, Q8 is disclosed. First and second output nodes OUTPUT, $\overline{\text{OUTPUT}}$ are connected to GND potential via an N-channel transistor Q1; Q4 having its gate connected to a respective input node REF, DATA and a P-channel transistor Q2, Q3 having its gate connected to the other input node. A pair of N-channel transistors Q5, Q6 are connected between the first and second output nodes and GND potential respectively and their gates are connected to the second and first output nodes respectively. Such a sense amplifier is capable of performing a sensing operation for a data input signal having any value between ground potential and power supply voltage. In addition, it is capable of performing a sequential sensing operation for multi-level data using a single sense amplifier.

## Description

The present invention relates to a sense amplifier which senses and amplifies the voltage level of data stored in memory cells within a semiconductor memory device, and more particularly to a sense amplifier which has a wide input range, for use in a nonvolatile semiconductor memory having memory cells capable of storing multi-level data as well as binary logic data.

With the development of manufacturing technologies, semiconductor memory devices have advanced in various ways. As one of these advancements, attempts to develop better sensing have continuously been made, while high density memory cell and high speed operations of the devices are accomplished. Sense amplifiers, which serves to sense and then amplify the voltage level of data readout from memory cells connected to the bit lines, have been developed in a number of different ways.

One conventional sense amplifier, for example, is capable of executing a sensing operation only in the event that the voltage level of an input signal is higher than the threshold voltage level of an N-channel transistor disposed in the input terminal of the sense amplifier. Therefore, the sense amplifier cannot implement the sensing operation for an input signal having a voltage level lower than the threshold voltage level of the N-channel transistor. Moreover, in the event that a high level input signal approximating the power supply voltage level is applied to the input terminal of the sense amplifier, a load transistor (typically, a P-channel transistor) and an input transistor (typically, an N-channel transistor) both become highly conductive so that the output level of a high level input signal does not reach the power supply voltage level, but reaches only up to about 70 to 80% of the power supply voltage. Accordingly, there is a problem in that the voltage margin applicable to the input terminal of the sense amplifier is not sufficient. When such a conventional sense amplifier is employed in a multi-level memory device storing a plurality of bits in a single memory cell, since the operational range of the memory cell is limited by the input range sensible by the sense amplifier, the permitted voltage difference between respective levels stored in the memory cell is reduced.

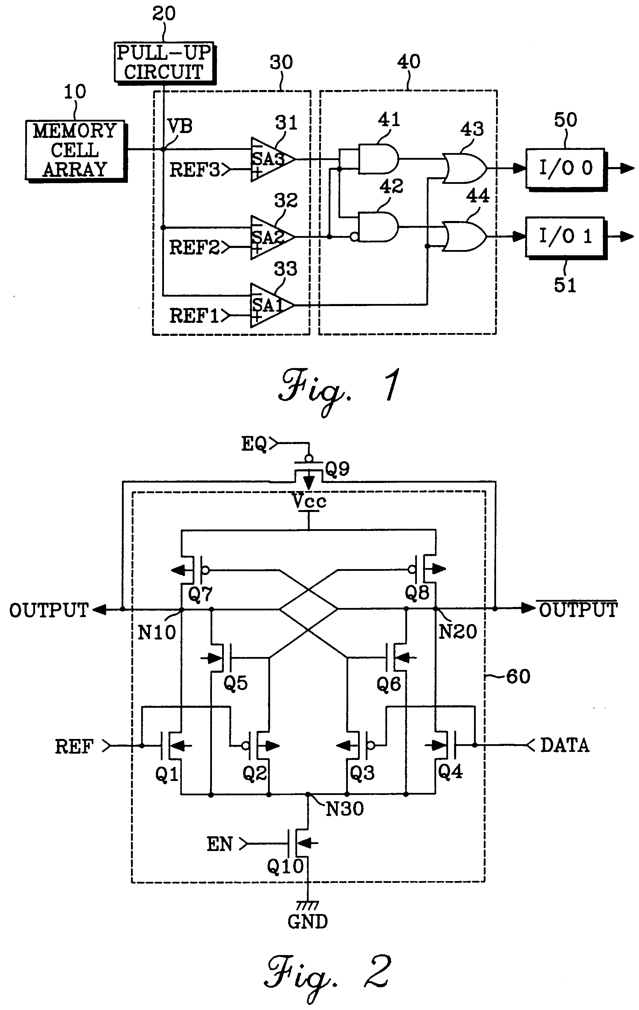

As shown in Fig. 1, separate sense amplifiers each adapted to be used in a corresponding input range are provided to solve the problem which has arisen in conventional sense amplifiers. This, however, results in an increase in area occupied by the sense amplifiers in the memory device, so that a high density memory device cannot be achieved. For better understanding of the present invention, the circuit configuration of the conventional sense amplifier will be discussed with reference to Fig. 1.

Fig. 1 is a circuit diagram illustrating the conventional sense amplifier, which is used in a read only memory (ROM) device where a plurality of bits are stored in a single memory cell. Reference voltages having different levels, such as, for example, REF1, REF2 and REF3 are applied to non-inverting input terminals (+) of sense amplifiers 33, 32 and 31, which sense amplifiers are included in a sense amplifying circuit 30. A bit line voltage VB, a common input signal determined by the memory cell array and a pull up circuit 20, is applied to the inverting input terminals (-). The sense amplifiers 31, 32 and 33 concurrently perform a sensing operation by comparing the bit line voltage VB with each of the reference voltages REF3, REF2 and REF1. The outputs of these sense amplifiers are encoded as most significant bit (MSB) and least significant bit (LSB), respectively, through a sequence of encode logic 40 and input/output terminals 50 and 51.

The conventional sense amplifier should include one or more sense amplifiers and encode logic, for sensing multi-level data, as shown in Fig. 1. Therefore, when the sense amplifiers are embodied on a single chip within a semiconductor integrated circuit, the area occupied by the sense amplifiers is large. Moreover, in the event that the sense amplifier is applied in a nonvolatile semiconductor memory device having a page structure, such as a NAND-type flash EEPROM (electrically erasable and programmable read only memory), requiring the arrangement of one sense amplifier per bit line or several bit lines, reduction in chip size in not possible.

Accordingly, it is an object of the present invention to provide an improved sense amplifier which is free from the above-mentioned problems.

It is another object of the present invention to provide a sense amplifier which is capable of performing a sensing operation for a data input signal having any level between ground potential and power supply voltage.

It is yet another object of the present invention to provide a sense amplifier which is capable of performing sequential sensing operations for multi-level data using a single sense amplifier, to reduce the IC area occupied, and being adapted for use in a semiconductor memory device having a page structure.

Accordingly, the present invention provides a sense amplifier having first and second input nodes and first and second output nodes comprising:
first conductivity means connected between the first output node and a first reference potential and having a conductivity which increases as the potential difference between the first and second input nodes increases;
second conductivity means connected between the second output node and the first reference potential and having a conductivity which decreases as the potential difference between the first and second input nodes increases.

Preferably, the first conductivity means comprises a transistor of a first channel type having its channel connected between the first output node and the first reference potential and its gate connected to the first input node and a transistor of a second channel type having its channel connected between the first output node and the first reference potential and its gate connected to the second input node; and the second conductivity means comprises a transistor of a first channel type having its channel connected between the second output node and the second reference potential and its gate connected to the second input node and a transistor of a second channel type having its channel connected between the second output node and the second reference potential and its gate connected to the first input node.

The sense amplifier preferably also includes third and fourth conductivity means connected between the first and second output nodes respectively and the first reference potential and having conductivities which are functions of the second and first output node potentials respectively such that the conductivities increase as the respective output node potentials approach the second reference potential from the first reference potential.

The third and fourth conductivity means may comprise a pair of transistors of a first channel type having their channels connected between the first and second output nodes and the first reference potential respectively and their gates connected to the second and first output nodes respectively.

The sense amplifier preferably also includes pull-up/pull-down means connected between the output nodes and a second reference potential. For example, fifth and sixth conductivity means may be connected between the first and second output nodes respectively and the second reference potential and having conductivities which are functions of the second and first output node potentials respectively such that the conductivities decrease as the respective output node potentials approach the second reference potential from the first reference potential.

The fifth and sixth conductivity means may comprise a pair of transistors of a second channel type having their channels connected between the first and second output nodes and the second reference potential respectively and their gates connected to the second and first output nodes respectively.

The first reference potential may be ground potential and the second reference potential may be a power supply voltage. The first channel type may be N-channel and the second channel type P-channel.

Preferably, the sense amplifier also includes equalising means for equalising the potentials of the output nodes, such as a transistor having its channel connected between the output nodes and its gate connected to receive an equalising control signal.

The first reference potential may be provided to a reference node via the channel of a control transistor having its gate coupled to receive a control signal.

The invention also extends to a semiconductor memory device including a sense amplifier circuit according to the invention.

A more complete appreciation of this invention, and many of its advantages, will be readily apparent as the it becomes better understood by reference to the following detailed description of a preferred embodiment when considered in conjunction with the accompanying drawings, in which:
Fig. 1 is a circuit diagram illustrating a conventional sense amplifier having encode logic;
Fig. 2 is a circuit diagram illustrating a sense amplifier according to the present invention; and
Figs. 3A to 3C are waveforms illustrating the relationship of voltage versus time of the input/output voltage levels in the sense amplifier of Fig. 2.

The term "sense amplifier" in the following description is used to indicate an electric circuit having the function of sensing a voltage level provided to a data output line of a memory cell within a semiconductor memory device and amplifying the sensed voltage level to supply the amplified voltage level to an output buffer. Another term "pull-down node" is a node at which the voltage level is substantially equal to ground potential level through conduction of the drain-source path of a pull-down transistor.

The construction of a sense amplifier according to the present invention will be explained with reference to Fig. 2. Referring to Fig. 2, showing a sense amplifier which is applicable in an EEPROM, there are provided an equalizing transistor Q9 which has its drain-source path connected between first and second output nodes N10 and N20 and receives an equalizing signal at its gate, and a sense amplifier 60 having a latch structure.

The sense amplifier 60 includes the first and second output nodes N10 and N20; a pull-down node N30; first and second N-channel transistors Q1 and Q5 and a first P-channel transistor Q3 whose drain-source paths are respectively connected in parallel between the first output node N10 and the pull-down node N30; third and fourth N-channel transistors Q4 and Q6 and a second P-channel transistor Q2 whose drain-source paths are respectively connected in parallel between the second output node N20 and the pull-down node N30. The gates of the first N-channel transistor Q1 and the second P-channel transistor Q2 are each connected to a reference voltage terminal REF, the gates of the third N-channel transistor Q4 and the first P-channel transistor Q3 are each connected to a data input terminal DATA, and the gates of the fourth N-channel transistor Q6 and the second N-channel transistor Q5 are each connected to the first and second output nodes N10 and N20. the circuit also includes a pull-down transistor Q10 responsive to an enable signal EN which has its drain-source path connected between the pull-down node N30 and a ground terminal GND; and third and fourth P-channel transistors Q7 and Q8 which are connected between a power supply voltage Vcc and the first and second output nodes N10 and N20 and have their respective gates connected to the second and first output nodes N20 and N10.

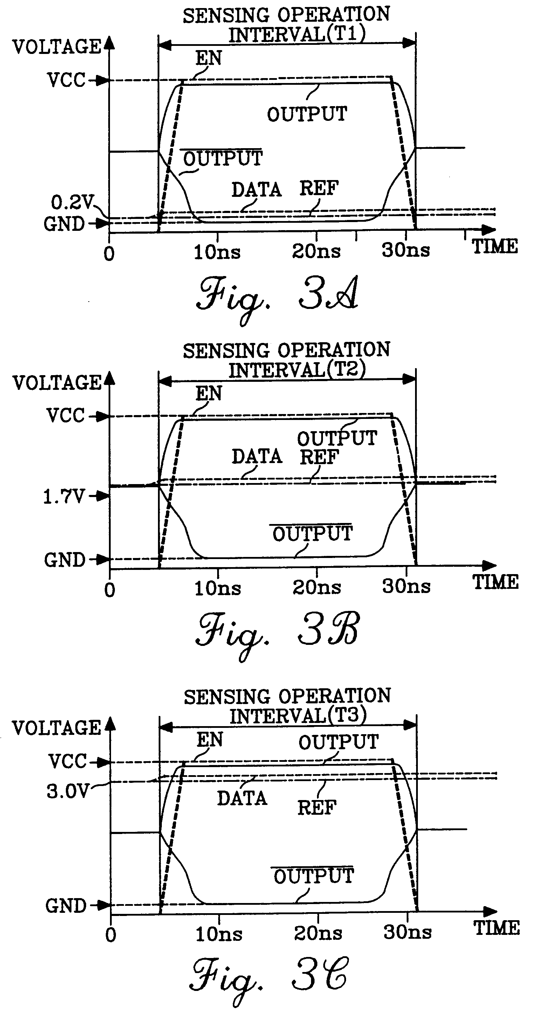

Figs. 3A to 3C are waveforms illustrating the relationship of voltage versus time of the input/output voltage levels in the sense amplifier of Fig. 2. The operation of the sense amplifier according to the present invention will be explained with reference to Figs. 2 and 3A to 3C.

Referring back to Fig. 2, since the gates of the first N-channel transistor Q1 and the second P-channel transistor Q2 are each connected to the reference voltage terminal REF and the gates of the third N-channel transistor Q4 and the first P-channel transistor Q3 are each connected to the data input terminal DATA, even though the power supply voltage Vcc level or the ground potential GND level is input to the data input terminal DATA, the sense amplifier 60 can execute a sensing operation, being activated by the enable signal EN going to a logic "high" state.

Now assuming that the threshold voltage of the N-channel transistors Q1 and Q4 within the sense amplifier 60 is Vth(n), suppose that the relationship of Vth(n) < V(REF) < V(DATA) is satisfied for the reference voltage V(REF), the input data voltage V(DATA) and the threshold voltage Vth(n). When a low voltage is applied to the P-channel transistors Q2 and Q3, respectively, so as to turn on them, the P-channel transistors Q2 and Q3 and N-channel transistors Q1 and Q4 operate as an input transistor. The operation of the circuit will now be explained. While the pull-down transistor Q10 is turned on by the enable signal EN, the drain-source paths of N-channel transistors Q1 and Q4 and P-channel transistors Q2 and Q3 are respectively conductive, and thus the output states of first and second output nodes N10 and N20 depend on the amount of current flowing to the pull-down node N30. In this case, since the N-channel transistor Q4 passes a larger amount of current than the N-channel transistor Q1 and the P-channel transistor Q2 passes a larger amount of current than the P-channel transistor Q3, the output voltage $\overline{\text{OUTPUT}}$ of the second output terminal maintains a considerably lower voltage level than the output voltage OUTPUT of the first output terminal.

When the output voltage $\overline{\text{OUTPUT}}$ is lowered, the N-channel transistor is turned off and thus the P-channel transistor Q7 passes a larger amount of current than the P-channel transistor Q8, thereby raising the output voltage OUTPUT to the power supply voltage. As the output voltage OUTPUT is high, the N-channel transistor Q6 passes a large amount of current and lowers the output voltage $\overline{\text{OUTPUT}}$ to the ground potential level with the N-channel transistor Q4.

Fig. 3B shows the voltage levels in the case where an intermediate voltage level higher than the threshold voltage level of the N-channel transistor and lower than the power supply voltage level is applied as the reference voltage and the input data voltage, respectively. Fig. 3C shows the voltage level in the case where a high level input amounting to the power supply voltage is applied as the reference voltage and the input data voltage, respectively. Here, the P-channel transistors Q2 and Q3 are turned off and the N-channel transistors Q1 and Q4 operate as the input transistor. In this case, the logic "high" level of the output voltage approximates the power supply voltage level (in the case of the power supply voltage of 3.3 volts, the output voltage is 3.25 volts), and the logic "low" level of the output voltage it at the ground potential level, all of which show almost full complementary metal-oxide-semiconductor (CMOS) level.

When the relationship of V(REF) < V(DATA) < Vth(n) is satisfied by the reference voltage V(REF), the input data voltage V(DATA) and the threshold voltage Vth(n), the circuit operation is as follows. When the pull-down transistor Q10 is turned on by the enable signal EN, the N-channel transistors Q1 and Q4 are turned off, even though the input signal is applied thereto. Since the P-channel transistor Q2 passes a larger amount of current than the P-channel transistor Q3, the output voltage $\overline{\text{OUTPUT}}$ maintains a considerably lower voltage level than the output voltage OUTPUT. When the output voltage $\overline{\text{OUTPUT}}$ level is lowered, the N-channel transistor Q5 is turned off and thus the P-channel transistor Q7 passes a larger amount of current than the P-channel transistor Q8, thereby raising the output voltage OUTPUT to the power supply voltage. As the output voltage OUTPUT is high, the N-channel transistor Q6 passes a large amount of current and lowers the output voltage $\overline{\text{OUTPUT}}$ to the ground potential level. A voltage drop for the threshold voltage Vth(n) is avoided in the output voltage OUTPUT by using the N-channel transistors Q5 and Q6, even if an input data voltage V(DATA) amounting to the power supply voltage is applied.

Fig. 3A is an input/output waveform showing a computer simulation obtained from the above operation. In the similar manner to Figs. 3B and 3C, Fig. 3A shows the voltage level, in which when a logic "low" level input voltage amounting to the ground potential level is applied to the data input terminal of the sense amplifier, the logic "high" level of the output voltage approximates the power supply voltage level, and the logic "low" level of the output voltage approximates the ground potential level.

When an input voltage lower than the threshold voltages of the N-channel transistors Q1 and Q4 is applied, in the event that the output voltage OUTPUT or $\overline{\text{OUTPUT}}$ goes from the logic "low" level to the logic "high" level, a high level of voltage amounting to the power supply voltage can be obtained, without requiring the N-channel transistor Q5 or the N-channel transistor Q6. On the contrary, in the event that the output voltage OUTPUT or $\overline{\text{OUTPUT}}$ goes from the logic "high" level to the logic "low" level, if the N-channel transistor Q5 or the N-channel transistor Q6 is not present, the N-channel transistors Q1 and Q4 are turned off. As a result, since only the P-channel transistors Q2 and Q3 pass current, the output voltage OUTPUT or$\overline{\text{OUTPUT}}$ does not fall to the ground potential level and is lowered to the level of | threshold voltage of P-channel transistor Q3| + input data voltage V(DATA)" or| threshold voltage of P-channel transistor Q2| + reference voltage V(REF). Therefore, so as to lower the output voltage of the logic "low" level to the ground potential level, the N-channel transistors Q5 and Q6 which can lower the output voltage OUTPUT or $\overline{\text{OUTPUT}}$ to the ground potential level are needed.

In the case where any signal except the above signals is applied, the feedback loop of "OUTPUT - Q8 - $\overline{\text{OUTPUT}}$ - Q5" or "$\overline{\text{OUTPUT}}$ - Q7 - OUTPUT - Q6" is formed. Here, the P-channel transistors Q7 and Q8 function to raise any one level of the output voltages OUTPUT and $\overline{\text{OUTPUT}}$ to the power supply voltage level, in the same manner as a latch of a typical sense amplifier. Further, the N-channel transistors Q5 and Q6, together with the N-channel transistors Q1 and Q4, function to lower either of the output voltages OUTPUT and $\overline{\text{OUTPUT}}$ to the ground potential level. Thus, the output voltages OUTPUT and $\overline{\text{OUTPUT}}$ obtain the power supply voltage level and the ground potential level. Thereby, the CMOS level output obtained in the above manner ensures a sufficient sensing margin irrespective of variations of the power supply voltage, since the circuit input terminal connected to the output terminal of the sense amplifier is stable for the input voltage of the logic "high" or "low" level. From the simulation results of the operation according to an embodiment of the present invention, the sensing margin detected is several millivolts.

The P-channel transistor Q9 acts as the equalizing circuit and receives the equalizing signal EQ at its gate, has its source connected to the output voltage $\overline{\text{OUTPUT}}$, and has its drain connected to the output voltage OUTPUT. When the equalizing signal EQ is at the logic "low" state, the output voltages OUTPUT and $\overline{\text{OUTPUT}}$ levels are equal thus increasing sensing speed. In the case where the P-channel transistor Q9 is not present, when the output voltage OUTPUT sensed first becomes the power supply voltage level, the time period taken for its transition to the ground potential is relatively long. However, when the P-channel transistor Q9 is present, it enables the output voltages OUTPUT and $\overline{\text{OUTPUT}}$ levels to be at an intermediate level between the power supply voltage level and the ground potential level. Therefore, when the voltage level is changed from the logic "high" state to the logic "low" state or from the logic "low" state to the logic "high" state, sensing speed increases.

As discussed above, the present invention provides an improved sense amplifier which has a wide input range, when applied in a multi-level sensing memory device, and thus is capable of sequentially sensing the multi-level bits stored in a memory cell using a single sense amplifier, without requiring a separate sense amplifier for each reference voltage as is required in the conventional art. Moreover, the sense amplifier according to the present invention has the advantage of reduction of area, when embodied in an integrated circuit.

Furthermore, the sense amplifier according to the present invention may be of course embodied in a multi-level flash memory device storing two or more bit information in a single memory cell.

While the present invention has been described above with reference to the preferred embodiment, it will be appreciated by those skilled in the art that various substitutions and modifications can be made without departing from the scope of the invention as set forth in the following claims.

## Claims

1. A sense amplifier having first and second input nodes and first and second output nodes comprising:
first conductivity means connected between the first output node and a first reference potential and having a conductivity which increases as the potential difference between the first and second input nodes increases;
second conductivity means connected between the second output node and the first reference potential and having a conductivity which decreases as the potential difference between the first and second input nodes increases.

2. A sense amplifier according to claim 1 in which:
the first conductivity means comprises a transistor of a first channel type having its channel connected between the first output node and the first reference potential and its gate connected to the first input node and a transistor of a second channel type having its channel connected between the first output node and the first reference potential and its gate connected to the second input node; and
the second conductivity means comprises a transistor of a first channel type having its channel connected between the second output node and the second reference potential and its gate connected to the second input node and a transistor of a second channel type having its channel connected between the second output node and the second reference potential and its gate connected to the first input node.

3. A sense amplifier according to any preceding claim further including third and fourth conductivity means connected between the first and second output nodes respectively and the first reference potential and having conductivities which are functions of the second and first output node potentials respectively such that the conductivities increase as the respective output node potentials approach the second reference potential from the first reference potential.

4. A sense amplifier according to claim 3 in which the third and fourth conductivity means comprise a pair of transistors of a first channel type having their channels connected between the first and second output nodes and the first reference potential respectively and their gates connected to the second and first output nodes respectively.

5. A sense amplifier according to any preceding claim including pull-up/pull-down means connected between the output nodes and a second reference potential.

6. A sense amplifier according to claim 5 in which the pull-up/pull-down means comprises fifth and sixth conductivity means connected between the first and second output nodes respectively and the second reference potential and having conductivities which are functions of the second and first output node potentials respectively such that the conductivities decrease as the respective output node potentials approach the second reference potential from the first reference potential.

7. A sense amplifier according to claim 6 in which the fifth and sixth conductivity means comprise a pair of transistors of a second channel type having their channels connected between the first and second output nodes and the second reference potential respectively and their gates connected to the second and first output nodes respectively.

8. A sense amplifier according to any preceding claim in which the first reference potential is ground potential and the second reference potential is a power supply voltage.

9. A sense amplifier according to any one of claims 2, 4 and 7 in which the first channel type is N-channel and the second channel type is P-channel.

10. A sense amplifier according to any preceding claim including equalising means for equalising the potentials of the output nodes.

11. A sense amplifier according to claim 10 in which the equalising means comprises a transistor having its channel connected between the output nodes and its gate connected to receive an equalising control signal.

12. A sense amplifier according to any preceding claim in which the first reference potential is provided to a reference node via the channel of a control transistor having its gate coupled to receive a control signal.

13. A sense amplifier as described herein with reference to and as illustrated in Fig. 2 of the accompanying drawings.

14. A semiconductor memory device including a sense amplifier circuit according to any preceding claim.
